# EUROPEAN PATENT SPECIFICATION

(11) **EP 1 233 517 B1**
(45) Date of publication and mention of the grant of the patent: **18.04.2012**
(21) Application number: 02002800.7
(22) Date of filing: 07.02.2002
(51) Int. Cl.: H03K 19/177

(54) **A system for rapid configuration of a programmable logic device**
System zur schnellen Konfiguration einer programmierbaren logischen Vorrichtung
Système de configuration rapide d'un dispositif logique programmable

(30) Priority: 09.02.2001 IN DE01382001
(43) Date of publication of application: 21.08.2002
(73) Proprietor: Sicronic Remote KG, LLC, Wilmington, DE 19801 (US)
(72) Inventor: Bal, Ankur, Ghaziabad 201002 (IN)
(74) Representative: Kazi, Ilya

(56) References cited:
- EP-A- 0 454 352
- US-A- 5 336 951
- US-A- 5 995 988
- US-A- 6 057 704

## Description

### Field of the Invention

The present invention relates to a system for rapid configuration of a programmable Logic Device.

### Background of the Invention

Programmable logic device, in particular FPGAs (field-programmable gate arrays) and CPLDs (complex programmable logic devices) consist of a plurality of memory elements/reconfigurable elements with the primary purpose of storing circuit information and controlling the programmable logic circuit behaviour. The reconfigurable elements in FPGAs / CPLDs are usually CMOS latches. These latches store information/data bits that decide the lookup table logic, the routing information, and other details which are solely dependent on the circuit being implemented in the given device. As the number of these latches is large, it takes quite some time to configure the FPGA/CPLD for a given circuit implementation. The configuration data is generated by the software tools that map, place and route the input circuit netlist.

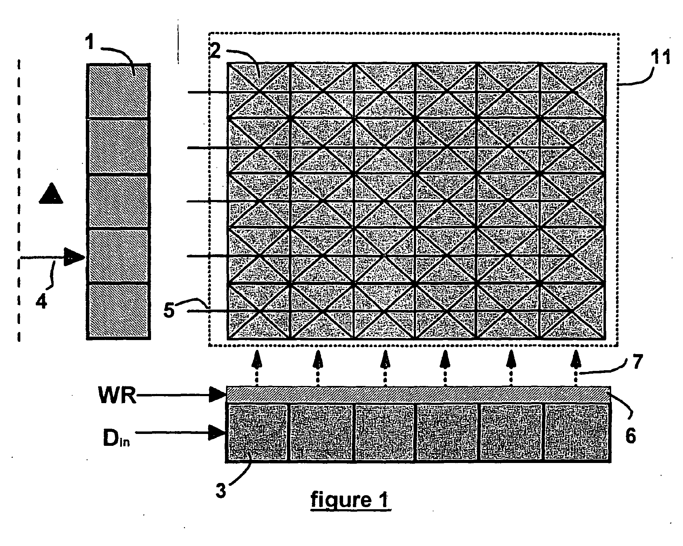

The known schemes use the straightforward concept as illustrated in figure 1 of the accompanying drawings. The configuration latches are connected as arrays of latches 11 with the write signal of the latches in rows tied together 5. A shift register structure1 exists beside the latch array which enables the write signal of the latches in rows, one row at a time. The write activation bit 4 shifts across the array to activate the write signals in rows. Another shift register3 exists whose length is equal to the number of columns in the latch array. The purpose of this register is to serially accept a data frame that is to be loaded into a particular row of the latch array. The length of this register may vary depending on any error correction or parity check circuits that might have been incorporated. A data frame is fully loaded into the shift register3 in 'n' clock cycles, where 'n' is the length of the shift register 3. A few more clock cycles are consumed in advancing the write control bit in the shift register 1. There may exist another write signal WR that activates only after the data frame to be loaded into 3 and the write control bit in the write control shift register1 are in place. The data frame load and the write signal increment 4 continue until all the configuration bits are loaded into the device. The control circuitry for executing and synchronizing the data frame load and the write increment operation is not shown and is well known to those skilled in the art. Thus, in the prior art, the total number of clock cycles needed to configure an FPGA/CPLD is greater than the total number of configuration latches in the given FPGA/CPLD.

In US patent no. 5,995,988 serial loading of bits in groups has been described which takes longer time for loading.

US-A-6, 057, 704 discloses a partially reconfigurable FPGA comprising column select circuits for selecting a logically continuous set of bits out of the total bits in the configuration memory; a row decoder and a frame register cooperating for selecting one or more bits in the selected set of bits that requires to be toggled; and pass transistors for changing the selected bits.

### The Summary of the Invention

The aim of this invention is to reduce the clock cycles by presetting all the configuration latches to a predetermined state and then selectively changing states of specific configuration latches in the latch array.

To achieve this aim, the invention provides a system and a method for rapid configuration of a programmable logic device as defined in appended claims 1 and 15, respectively. In practice, the system includes:
- a configuration memory comprising a plurality of memory elements for defining the operation of the programmable logic device,
- first means for selecting a logically continuous set of bits out of the total bits in the configuration memory,
- a second means for selecting one or more bits in the selected set of bits that require to be toggled, and
- a third means for changing said selected bits.

The first means comprises a write control shift register for selecting a row of the configuration memory array of said programmable logic device.

The second means comprises a decoder for selecting one column at a time of the configuration memory array of the programmable logic device.

The third means comprises a pass transistor for connecting the input of memory latch storing said bit to a logic '0' or logic '1' level.

Means is provided to generate the shift signal for the write control shift register (WCSR), by a combination of a defined output of the second means and a clock signal.

The means for generating the shift signal comprises an AND gate and the decoder is a binary decoder.

Multiple programmable logic devices are enabled sequentially by means of a sequencing mechanism.

A counter is provided with the programmable logic device for selecting the programmable logic device location and is stopped by signal generated by the programmable logic device.

The input to the decoder is from a memory containing the addresses of the locations of bits / bit clusters that are to be changed.

The memory contains the values of only those locations that, in the present configuration, differ from the desired values in the new configuration, so as to minimize memory size and configuration time.

The configuration memory is programmed in multiple bits at a time, using a plurality of selection means and toggling means.

The selection means are decoders.

The sequencing mechanism is a Daisy Chain mechanism.

### Brief Description of the Drawings

The invention will now be described with reference to the accompanying drawings.

FIG. 1 shows prior art for loading of configuration data in a programmable logic device consisting of reconfigurable elements.

FIG. 2 shows a system for configuring a programmable logic device, according to this invention.

FIG. 3 shows the arrangement for selective programming of '0' values in one row of the configuration memory.

FIG. 4 shows the arrangement for selective programming of '0' values in a multiplicity of rows of the configuration memory.

FIG. 5 shows the basic arrangement for programming a '0' or '1' value in a single latch of the configuration memory.

FIG. 6 shows the latch structure of the configuration memory of the FPGA/CPLD.

FIG. 7 shows the arrangement for controlling the selective programming of the configuration memory using a counter and a memory device, according to this invention.

FIG. 8 shows the configuration of more than one FPGA/CPLD device connected in a Daisy Chain.

FIG. 9 shows a sample memory content.

FIG. 10 shows an arrangement for programming multiple values simultaneously using a plurality of decoders and/or shift registers.

### Detailed Description of the Preferred Embodiments

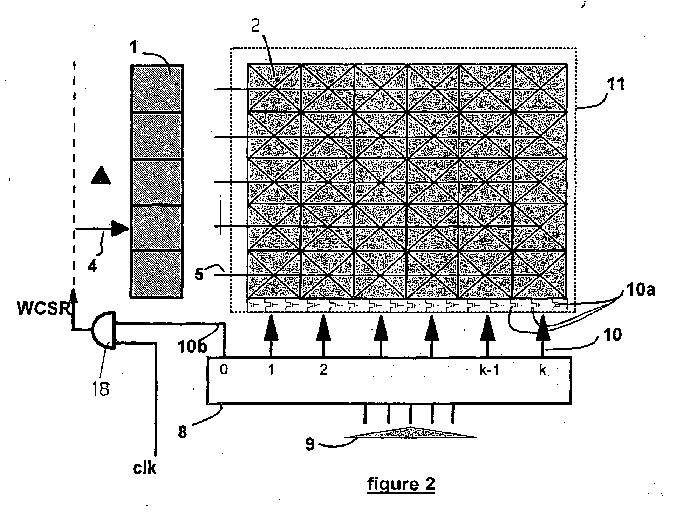

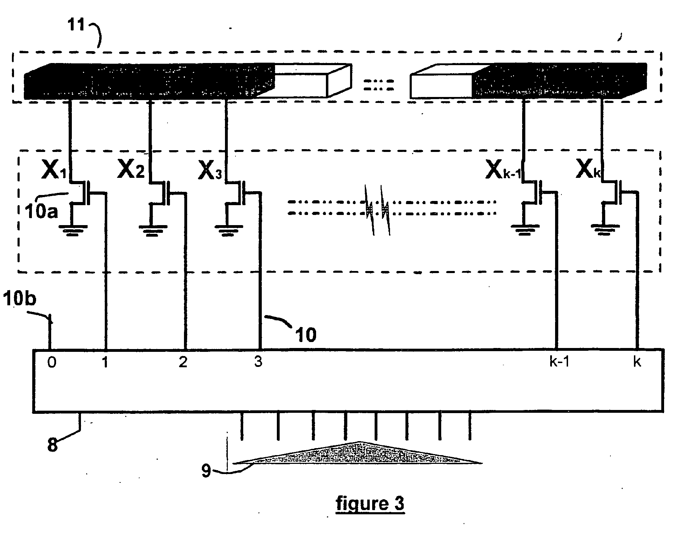

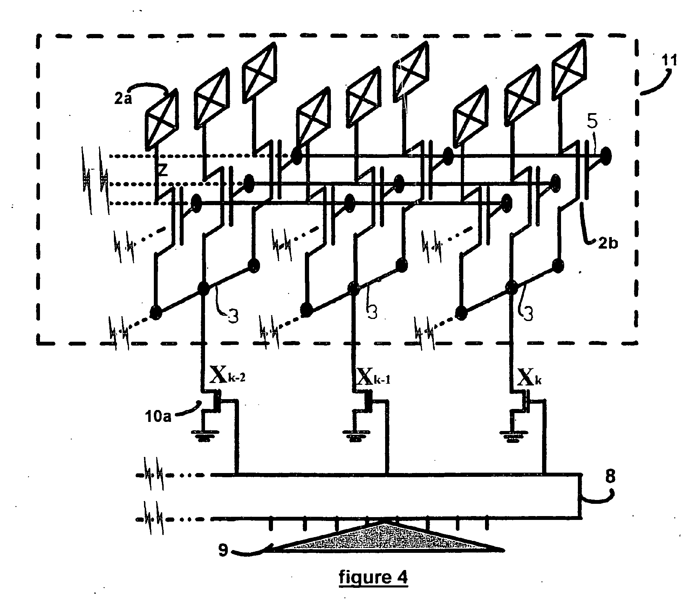

Referring to the embodiment in figure 2, 11 represents an array of memory elements arranged in an identical way as in the prior art. Preferably, the memory elements are latches 2a, e.g. CMOS latches. A decoder 8 has 'n' inputs 9 and 2ⁿ outputs 10, 10b. WCSR is a control signal derived from the decoder and operates as a clock signal for the write control bit in a shift register 1, as explained later. Assuming 8 inputs 9 to the decoder 8 in the present embodiment there will be 256 outputs, i.e. K=255. This also implies that there will be 255 columns 3 in the latch array of the present embodiment, as explained later. Figures 3 and 4 illustrate details of figure 2. The gates of write pass transistors 2b in each row 5 of the latch array 11 are tied together and connected to the write control shift register 1. It can also be seen that first terminals of the pass transistors 2b in a column are tied together and connected to an own pull down n-channel pass transistor 10a whose gate is controlled by the decoder output 10. The second terminals of the pass transistors 2b are connected to own latches 2a. The write control shift register 1 shifts the write signal bit in order to activate one row 5 of the latch array 11 at a time. The 8 lines entering the decoder 8 receive signals from the memory/software-hardware interface that contains configuration data.

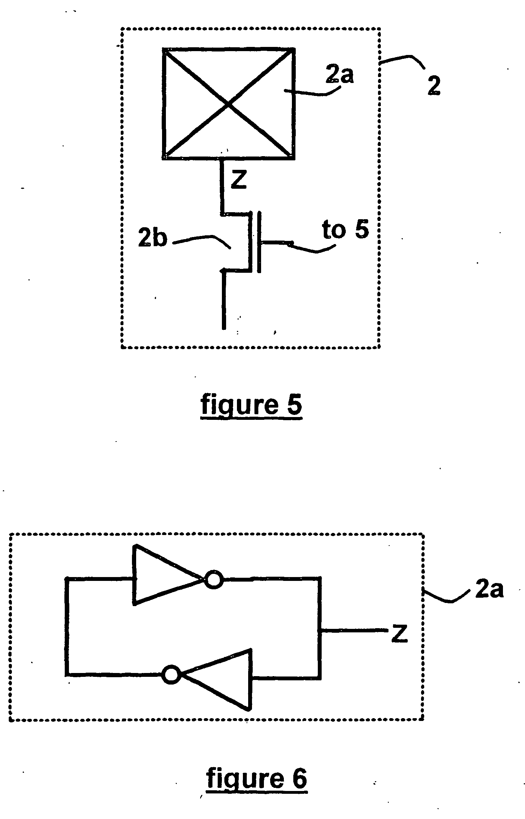

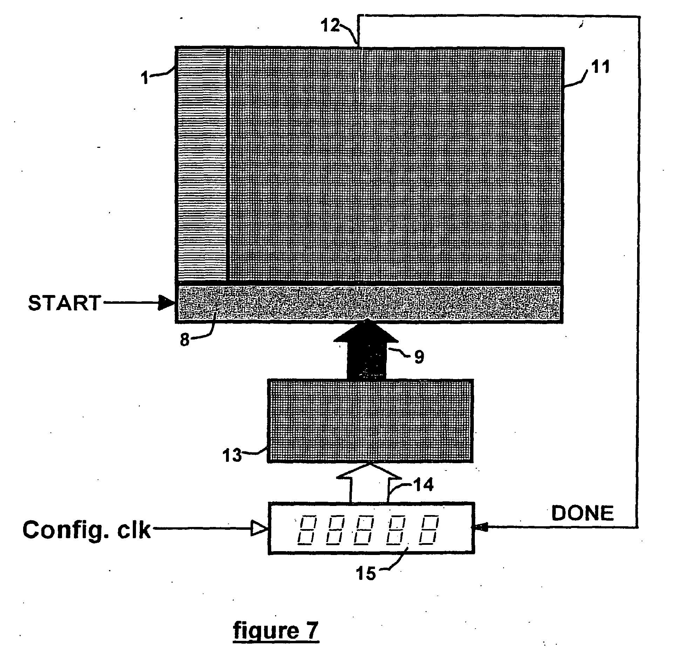

The following sequence of events best explain the configuration for the present embodiment:
1. A global signal resets all the latches 2a in the array such that all nodes Z in figure 5 are preset to logic 1. Figures 6 illustrates the basic latch structure used in the present embodiment of the proposed invention and are well known to those skilled in the art.
2. If an on board memory is used to store the configuration bits, the data is organized such that the memory contains locations of those latches in the configuration latch array whose data is required to be toggled to logic 0. It is apparent that the memory output will correspond to the decoder input, and as such will be 8 bits wide.
3. Referring to figures 2 and 3, a data frame may be 255 bits wide, in order to eliminate the WR signal in the prior art (figure 1) altogether. One of the 256 possible outputs from the decoder is wired as a WCSR, preferably the zero output, which of course corresponds to the zeroth output 10b. This output becomes operative during the transition interval of the write control shift register signal (WCSR) to an adjacent row in the latch array 11. The WCSR signal acts as a clock to the write control shift register 1 that shifts a logic 1 across the shift register1, the rest of which is all set to logic zero. It is similar in operation to a ring counter and is well known to those skilled in the art. In other words once a row in the latch array is configured, the decoder input is made zero and only then does the WCSR signal shift the activation bitlogic 1 to an adjacent register cell in the shift register1 in order to enable the adjacent row in the latch array for configuration. The zeroth output 10b of the decoder 8 is ANDed in an AND gate 18 with a synchronizing clock clk to synchronize the operation. This clock is preferably the clock driving the counter 15 (figure 7).

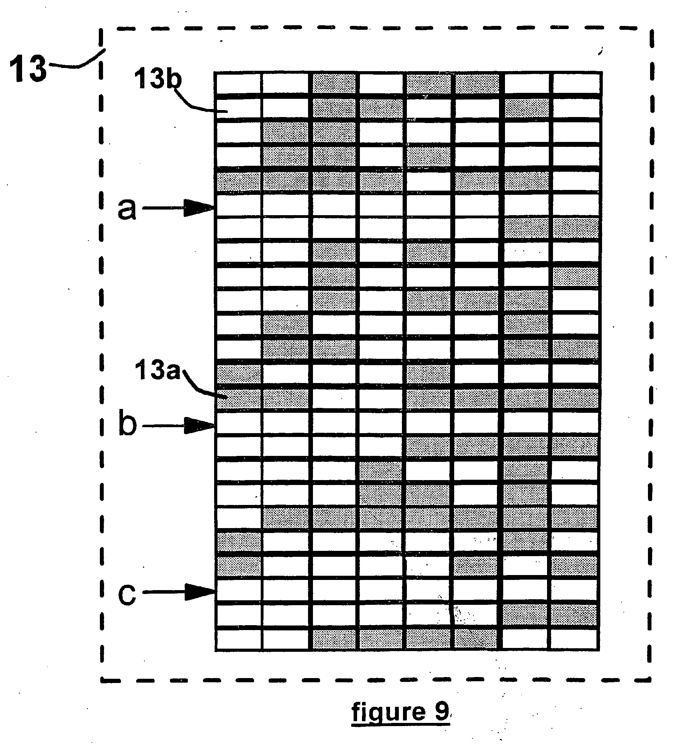

It is clear by now that the latch array 11 is configured one row 5 at a time. The first cell (bottom-most cell in figure 2) of the shift register1 is initialized to logic 1 to initiate ring counter operation. As shown in figure 7, a configuration clock drives a counter 15which begins the configuration process by addressing the memory contents as it advances count. The output of the counter 15 is connected to a memory address bus14 that addresses a memory 13. The output of the memory 13 (8 bit wide) is connected to the input 9 of the decoder 8 which in turn pulls down the latches 2a in that order, in the enabled row. Once the desired latch cells in the row have been pulled down (connected to ground), a zero output from the memory 13 to the decoder 8 pulls up the WCSR, which in turn advances the shift register1 at the arrival of the synchronizing clock clk. Now the row adjacent to the previous one is enabled in the latch array 11. The process continues till the device is fully/partially configured, depending on the design. An important point to note is that the data to be stored in different rows of the latch array 11 are separated from each other by a row of zeros in the memory 13, so as to generate the WCSR signal properly. Figure 9 shows a sample memory's content. Shaded regions 13a are logic ones and non-shaded regions 13b are logic zeros. It can be seen that 'a', 'b' and 'c' point out the zero data, which demarcate configuration information to be stored to different rows. Other than synchronizing the WCSR signal the synchronizing clock clk becomes very important when the memory 13 contains consecutive zeros. These zeroes indicate row skip operations, which would not have been carried out if decoder output 10b would directly drive the WCSR line.

Once the configuration is complete, the counter may be halted by a signal generated by the FPGA/CPLD. Referring to figure 7 which shows a top level of the device, the memory13 and the counter15, configuration is enabled by a START signal & inhibited by a DONE signal. These signals can be generated in many known ways.

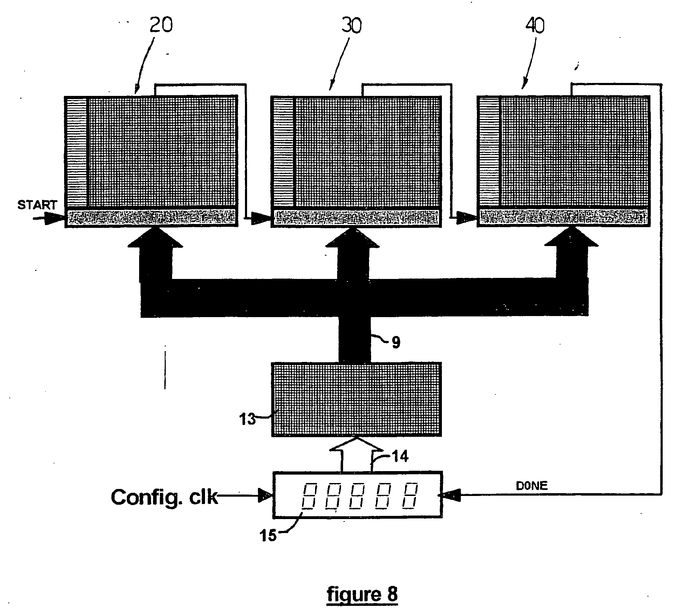

More than one device can be configured by a technique illustrated in figure 8. This scheme is similar to the Daisy chain technique used for configuring multiple FPGAs in current day devices. START and DONE signals are sequentially connected to enable configuration for devices 20, 30 and 40; in that order. The memory output bus is common to the decoder inputs of the three devices. Counter operation and memory organization remain the same as for a single device, the only difference being in counter and memory size for accommodating data for the three devices.

The aforementioned methodologies for the configuration of FPGAs/CPLDs is fast compared to the previous techniques. But at the same time the proposed technique has a major memory overhead, which can be minimized by clever design and configuration data manipulation. Some possible embodiments of the present invention, which minimize the memory overhead are now described.

In one embodiment of the present invention the latches 2a may be pulled up (set to logical ones) instead of being pulled down by the decoder arrangement. It can be decided whether to incorporate pull up or pull down transistors by assessing the configuration bit stream for logic zeros & ones. The FPGA/CPLD can be designed so as to maximize logic zeros or logic ones for its configuration latches during circuit implementation in the device. Another advanced embodiment is possible which has the flexibility of both pulling up & pulling down of configuration latches. Such an FPGA/CPLD could be reconfigured from some present configuration without presetting all the latches to logic zero or logic one. The memory driving the decoder is loaded with only the contents of those configuration memory location that are different in the new configuration map with respect to the present contents.

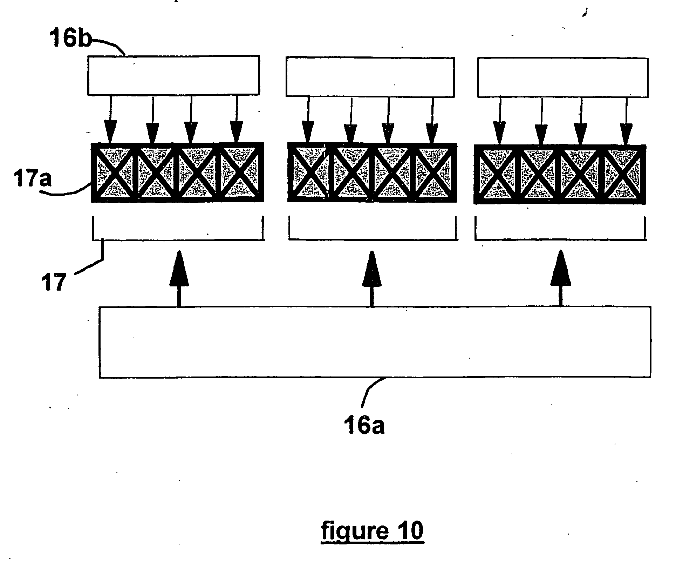

The schemes described till now talk only about changing/toggling single bits in the configuration latch array. Other interesting embodiments of the present invention are possible which address the issue of granularity. A decoder hierarchy, in which a plurality of decoders in different hierarchies selects variable chunks of configuration latches in the array, is possible and thus extending the invention to a coarser latch array. Referring to figure 10, a decoder 16a can select latches in groups of four 17. These latches17a can further be loaded with the desired data through a secondary decoder or a serial-in parallel-out shift register 16b.

Thus, an in-circuit, rapid reconfiguration is attainable by the proposed configuration architecture and its embodiments. The decoders used in various embodiments of the present invention can also be reused as FPGA/CPLD logic resources once the configuration process is complete. This resource sharing may not be possible in some embodiments.

Finally, it is clear that numerous variations and modifications may be made to the system described and illustrated herein, all falling within the scope of the invention, as defined in the attached claims. In particular, though the best mode implementation shows the write control shift register selecting a complete row of the configuration memory at a time, the invention covers different logically continuous set of bits and includes the possibility of the write control shift register selecting multiple rows, or a submultiple of a row if required. Furthermore, the selection operation by the write control shift register 1 may not necessarily be performed in a sequential manner.

## Claims

1. A system for rapid configuration of a programmable logic device including a configuration memory (11) comprising a plurality of memory elements (2a) for defining the operation of the programmable logic device, including:
- first means (1) for selecting a logically continuous set of bits out of the total bits in the configuration memory (11),
- a second means (8) for selecting one or more bits in the selected set of bits that require to be toggled, and
- a third means (10a) for changing said selected bits, **characterized in that** the first means (1) comprises a write control shift register (1) for selecting a row (5) of the configuration memory of said programmable logic device and
the second means (8) includes an output (10b) coupled to an input (4) of said first means (1) for supplying a control signal derivable from said output of the second means, the control signal (WCSR) operating as a clock signal for shifting a write control bit in the first means (1).

2. The system as claimed in claim 1, wherein said second means comprises a decoder (8) for selecting one column (3) at a time of the configuration memory (11) of said programmable logic device.

3. The system as claimed in claim 1 or 2, wherein said third means is a pass transistor (10a) for connecting the input of a memory element (2a) storing said bit to a logic '0' or logic '1' level.

4. The system as claimed in any of claims 1-3, wherein means is provided to generate a shift signal (WCSR) for the write control shift register (1), by a combination of said output (10b) of said second means (8) and a clock signal (clk).

5. The system as claimed in claim 4, wherein said means is an AND gate (18).

6. The system as claimed in claim 2, wherein said decoder (8) is a binary decoder.

7. The system as claimed in any of claims 1-6, wherein multiple programmable logic devices (20, 30, 40) are enabled sequentially by means of a sequencing mechanism.

8. The system as claimed in any of claims 1-7, wherein a counter (15) is provided for selecting the programmable logic device location and is stopped by signal generated by said programmable logic device.

9. The system as claimed in claim 2, wherein the input to said decoded (8) is from a memory (13) containing the addresses of the locations of bits or bit clusters that are to be changed.

10. The system as claimed in claim 9, wherein said memory (13) contains the values of only those locations differing in the present configuration from the desired values in the new configuration.

11. The system as claimed in claims 9 or 10, wherein said configuration memory (11) is programmed in multiple bits at a time, using a plurality of selection means and toggling means.

12. The system as claimed in claim 11, wherein said selection means are decoders (16a, 16b).

13. The system as claimed in claim 7, wherein said sequencing mechanism is a Daisy Chain mechanism.

14. The system according to any of the preceding claims, wherein said configuration memory (11) comprises an array of latches (2a).

15. A method for rapid configuration of a programmable logic device including a configuration memory (11), including:
selecting a logically continuous set of bits out of the total bits in the configuration memory (11) by a first means (1),
selecting one or more bits in the selected set of bits that require to be toggled by a second means (8), and
changing said selected bits that require to be toggled by a third means (10a),
**characterized by**
selecting said logically continuous set of bits comprises generating a write signal bit in a write control shift register (1) for selecting a row (5) configuration memory,
further comprising, after selecting one or more bits in the selected set of bits, deriving a control signal from an output of the second means coupled to an input of the first means, and supplying the control signal (WCSR) operating as a clock signal for shifting the write control bit.

16. A method according to claim 15, wherein the second means comprises a decoder, the method comprising selecting by the decoder each time, one column (3) of the configuration memory (11) of said programmable logic device.

17. A method according to claim 15 or 16, wherein the control signal (WCSR) is obtained by combining the selected bit that requires to be toggled from an output of the second means, with a clock signal (clk).

18. A method according to any of claims 15-17 further comprising sequentially enabling multiple programmable logic devices (20, 30, 40) by means of a sequencing mechanism.

19. A method according to claim 18, wherein the sequencing mechanism is a Daisy Chain mechanism.

20. A method according to any of claims 15-17, further comprising the steps of generating a counting signal by a counter for selecting the programmable logic device location and stopping the counting signal by a signal generated by said programmable logic device.

## Patentansprüche

1. Ein System zur schnellen Konfiguration einer programmierbaren logischen Vorrichtung, welche einen Konfigurationsspeicher (11) beinhaltet, welcher eine Vielzahl von Speicherelementen (2a) zum Definieren der Funktion der programmierbaren logischen Vorrichtung umfasst, beinhaltend:
- erste Einrichtungen (1), zum Auswählen eines logischen kontinuierlichen Satzes von Bits aus den gesamten Bits in dem Konfigurationsspeicher (11),
- eine zweite Einrichtung (8), zum Auswählen eines oder mehrerer Bits aus dem ausgewählten Satz von Bits, die benötigt werden, um umgeschaltet zu werden, und
- eine dritte Einrichtung (10a) zum Verändern der ausgewählten Bits,
**dadurch gekennzeichnet, dass**
- die erste Einrichtung (1) ein Schreib-Steuerungsschieberegister (1) zum Auswählen einer Reihe (5) aus dem Konfigurationsspeicher der programmierbaren logischen Vorrichtung umfasst, und
- die zweite Einrichtung (8) einen Ausgang (10b) beinhaltet, der mit einem Eingang (4) der ersten Einrichtung (1) verbunden ist, um ein vom Ausgang der zweiten Einrichtung ableitbares Steuersignal zu liefern, wobei das Steuersignal (WCSR) als ein Taktsignal zum Verschieben eines Schreib-Steuerbits in die erste Einrichtung (1) funktioniert.

2. Das System wie beansprucht in Anspruch 1, wobei die zweite Einrichtung einen Decoder (8) zum Auswählen einer Spalte (3) zu einer Zeit des Konfigurationsspeichers (11) der programmierbaren logischen Vorrichtung umfasst.

3. Das System wie beansprucht in Anspruch 1 oder 2, wobei die dritte Einrichtung ein Pass-Transistor (10a), zum Verbinden des Eingangs von einem Speicherelement (2a), welches den Bit auf einem logischen "0" oder logischen "1"-Pegel speichert, ist.

4. Das System wie beansprucht in einem der Ansprüche 1-3, wobei eine Einrichtung bereitgestellt ist, um ein Shift-Signal (WCSR) für das Schreib-Steuerschieberegister (1) zu erzeugen, durch eine Kombination des Ausgangs (10b) der zweiten Einrichtung (8) und eines Taktsignals (clk).

5. Das System wie beansprucht in Anspruch 4, wobei die Einrichtung ein UND-Gate (18) ist.

6. Das System wie beansprucht in Anspruch 2, wobei der Decoder (8) ein binärer Decoder ist.

7. Das System wie beansprucht in einem der Ansprüche 1-6, wobei mehrere programmierbare logische Vorrichtungen (20, 30, 40) aufeinander folgend mittels eines Sequenzierungsmechanismus aktiviert werden.

8. Das System wie beansprucht in einem der Ansprüche 1-7, wobei ein Zähler (15) bereitgestellt ist, zum Auswählen der programmierbaren logischen Vorrichtungsstelle und durch ein Signal gestoppt wird, welches durch die programmierbare logische Vorrichtung erzeugt ist.

9. Das System wie beansprucht in Anspruch 2, wobei der Eingang zu dem Decoder (8) von einem Speicher (13) ist, der die Adressen der Stellen der Bits oder Bit-Cluster, welche zu ändern sind, enthält

10. Das System wie beansprucht in Anspruch 9, wobei der Speicher (13) die Werte von nur denjenigen Stellen enthält, welche sich in der dargestellten Konfiguration von den gewünschten Werten in der neuen Konfiguration unterscheiden.

11. Das System wie beansprucht in den Ansprüchen 9 oder 10, wobei der Konfigurationspeicher (11) zu einer Zeit in mehrere Bits programmiert ist, wobei eine Vielzahl von Auswahl-Einrichtungen und Umschalt-Einrichtungen verwendet sind.

12. Das System wie beansprucht in Anspruch 11, wobei die Auswahleinrichtungen Decoder (16a, 16b) sind.

13. Das System wie beansprucht in Anspruch 7, wobei der Sequenzierungsmechanismus ein Daisy-Chain-Mechanismus ist.

14. Das System nach einem der vorhergehenden Ansprüche, wobei der Konfigurationsspeicher (11) ein Array von Signalspeichern (2a) umfasst.

15. Ein Verfahren zur schnellen Konfiguration von einer programmierbaren logischen Vorrichtung, die einen Konfigurationsspeicher (11) beinhaltet, beinhaltend:
Auswählen eines logisch kontinuierlichen Satzes von Bits aus den gesamten Bits in dem Konfigurationspeicher (11) durch eine erste Einrichtung (1),
Auswählen eines oder mehrerer Bits in dem ausgewähltem Satz von Bits, welche erfordern, durch eine zweite Einrichtung (8) umgeschaltet zu werden, und
Ändern der ausgewählten Bits, welche erfordern umgeschaltet zu werden, durch eine dritte Einrichtung (10a),
**gekennzeichnet, durch**
die Auswahl des logisch kontinuierlichen Satzes von Bits das Erzeugen eines Schreib-Signalbits in einen Schreib-Steuerungsschieberegister (1) zum Auswählen eines Reihen (5) -Konfigurationsspeichers umfasst, weiterhin umfassend, nach Auswählen eines oder mehrerer Bits in dem ausgewählten Satz von Bits, Herleiten eines Steuersignals von einem Ausgang der zweiten Einrichtung, welche mit einem Eingang der ersten Einrichtung verbunden ist und Liefern des Steuersignals (WCSR), welches als Taktsignal zum Verschieben des Schreib-Steuerbits funktioniert.

16. Ein Verfahren nach Anspruch 15, wobei die zweite Einrichtung einen Decoder umfasst, wobei das Verfahren ein Auswählen einer Spalte (3) des Konfigurationsspeichers (11) der programmierbaren logischen Vorrichtung durch den Decoder zu jeder Zeit umfasst.

17. Ein Verfahren nach einem der Ansprüche 15 oder 16, wobei das Steuersignal (WCSR) durch Kombinieren des ausgewählten Bits, welche erfordern von einem Ausgang der zweiten Einrichtung umgeschaltet zu werden, mit einem Taktsignal (clk), erhalten wird.

18. Ein Verfahren nach einem der Ansprüche 15-17, weiterhin umfassend sequenzielles Aktivieren mehrerer programmierbarer logischer Vorrichtungen (20, 30, 40) mittels eines Sequenzierungsmechanismus.

19. Ein Verfahren nach Anspruch 18, wobei der Sequenzierungsmechanismus ein Daisy-Chain-Mechanismus ist.

20. Ein Verfahren nach einem der Ansprüche 15-17, weiterhin umfassend die Schritte des Erzeugens eines Zählsignals durch einen Zähler, zum Auswählen der programmierbaren logischen Vorrichtungsstelle und des Stoppens des Zählsignals durch ein Signal, welches durch die programmierbare logische Vorrichtung erzeugt wird.

## Revendications

1. Système pour la configuration rapide d'un dispositif logique programmable comprenant une mémoire de configuration (11) comprenant une pluralité d'éléments de mémoire (2a) pour définir le fonctionnement du dispositif logique programmable, comprenant :
- un premier moyen (1) pour sélectionner un ensemble logiquement continu de bits parmi le nombre total de bits dans la mémoire de configuration (11),
- un deuxième moyen (8) pour sélectionner un ou plusieurs bits dans l'ensemble sélectionné de bits qui doivent être basculés, et
- un troisième moyen (10a) pour changer lesdits bits sélectionnés, **caractérisé en ce que**
le premier moyen (1) comprend un registre à décalage de commande d'écriture (1) pour sélectionner une ligne (5) de la mémoire de configuration dudit dispositif logique programmable et
le deuxième moyen (8) comprend une sortie (10b) couplée à une entrée (4) dudit premier moyen (1) pour fournir un signal de commande pouvant être obtenu à partir de ladite sortie du deuxième moyen, le signal de commande (WCSR) fonctionnant comme un signal d'horloge pour décaler un bit de commande d'écriture dans le premier moyen (1).

2. Système selon la revendication 1, dans lequel ledit deuxième moyen comprend un décodeur (8) pour sélectionner une colonne (3) à la fois de la mémoire de configuration (11) dudit dispositif logique programmable.

3. Système selon la revendication 1 ou 2, dans lequel ledit troisième moyen est un transistor de passage (10a) pour connecter l'entrée d'un élément de mémoire (2a) stockant ledit bit à un niveau logique "0" ou à un niveau logique "1".

4. Système selon l'une quelconque des revendications 1 à 3, dans lequel un moyen est prévu pour générer un signal de décalage (WCSR) pour le registre à décalage de commande d'écriture (1), par une combinaison de ladite sortie (10b) dudit deuxième moyen (8) et d'un signal d'horloge (clk).

5. Système selon la revendication 4, dans lequel lesdits moyens sont une porte ET (18).

6. Système selon la revendication 2, dans lequel ledit décodeur (8) est un décodeur binaire.

7. Système selon l'une quelconque des revendications 1 à 6, dans lequel plusieurs dispositifs logiques programmables (20, 30, 40) sont validés séquentiellement au moyen d'un mécanisme de séquencement.

8. Système selon l'une quelconque des revendications 1 à 7, dans lequel un compteur (15) est prévu pour sélectionner la position du dispositif logique programmable et est arrêté par un signal généré par ledit dispositif logique programmable.

9. Système selon la revendication 2, dans lequel l'entrée vers ledit décodeur (18) provient d'une mémoire (13) contenant les adresses des positions de bits ou grappes de bits qui doivent être changés.

10. Système selon la revendication 9, dans lequel ladite mémoire (13) contient les valeurs des seules positions différant dans la configuration courante des valeurs désirées dans la nouvelle configuration.

11. Système selon les revendications 9 ou 10, dans lequel ladite mémoire de configuration (11) est programmée en bits multiples à la fois, en utilisant une pluralité de moyens de sélection et de moyens de basculement.

12. Système selon la revendication 11, dans lequel lesdits moyens de sélection sont des décodeurs (16a, 16b).

13. Système selon la revendication 7, dans lequel ledit mécanisme de séquencement est un mécanisme de connexion en guirlande.

14. Système selon l'une quelconque des revendications précédentes, dans lequel ladite mémoire de configuration (11) comprend un réseau de bascules (2a).

15. Procédé pour la configuration rapide d'un dispositif logique programmable comprenant une mémoire de configuration (11), comprenant :
la sélection d'un ensemble logiquement continu de bits parmi le nombre total de bits dans la mémoire de configuration (11) par un premier moyen (1),
la sélection d'un ou plusieurs bits dans l'ensemble sélectionné de bits qui doivent être basculés par un deuxième moyen (8), et
le changement desdits bits sélectionnés qui doivent être basculés par un troisième moyen (10a), **caractérisé en ce que**
la sélection dudit ensemble logiquement continu de bits comprend la génération d'un bit de signal d'écriture dans un registre à décalage de commande d'écriture (1) pour sélectionner une ligne (5) de la mémoire de configuration ,
comprenant en outre, après la sélection d'un ou plusieurs bits dans l'ensemble sélectionné de bits, l'obtention d'un signal de commande à partir d'une sortie du deuxième moyen couplée à une entrée du premier moyen, et la fourniture du signal de commande (WCSR) fonctionnant comme un signal d'horloge pour décaler le bit de commande d'écriture.

16. Procédé selon la revendication 15, dans lequel le deuxième moyen comprend un décodeur, le procédé comprenant la sélection par le décodeur à chaque fois d'une colonne (3) de la mémoire de configuration (11) dudit dispositif logique programmable.

17. Procédé selon la revendication 15 ou 16, dans lequel le signal de commande (WCSR) est obtenu en combinant le bit sélectionné qui doit être basculé en provenance d'une sortie du deuxième moyen avec un signal d'horloge (clk).

18. Procédé selon l'une quelconque des revendications 15 à 17, comprenant en outre la validation séquentielle de dispositifs logiques programmables multiples (20, 30, 40) au moyen d'un mécanisme de séquencement.

19. Procédé selon la revendication 18, dans lequel le mécanisme de séquencement est un mécanisme de connexion en guirlande.

20. Procédé selon l'une quelconque des revendications 15 à 17, comprenant en outre les étapes de génération d'un signal de comptage par un compteur pour sélectionner la position du dispositif logique programmable et arrêter le signal de comptage par un signal généré par ledit dispositif logique programmable.
